# EUROPÄISCHE PATENTANMELDUNG

(11) **EP 1 679 945 A1**
(43) Veröffentlichungstag der Anmeldung: **12.07.2006**
(21) Anmeldenummer: 05028773.9
(22) Anmeldetag: 31.12.2005
(51) Int. Cl.: H05K 9/00, B32B 5/14, D04H 13/00, B32B 15/14

(54) **Verwendung von Schichtmaterialien zur Abschirmung von elektromagnetischen Wellen**

(30) Priorität: 07.01.2005 DE 102005001063
(71) Anmelder: Johns Manville Europe GmbH, 86399 Bobingen (DE)
(72) Erfinder: Greiser, Wolfgang, Dr., 86356 Neusäss (DE)
(74) Vertreter: Luderschmidt, Schüler & Partner GbR

(57) **Zusammenfassung**

Die vorliegende Erfindung betrifft die Verwendung von einem Schichtmaterial zur Abschirmung von elektromagnetischen Wellen, wobei das Schichtmaterial mindestens eine Faser umfassende Schicht sowie mindestens eine Aluminiumschicht umfasst und die Aluminiumschicht eine Dicke von mindestens 10 µm aufweist.

## Beschreibung

Die vorliegende Erfindung betrifft die Verwendung von einem Schichtmaterial zur Abschirmung von elektromagnetischen Wellen, wobei das Schichtmaterial mindestens eine faserumfassende Schicht sowie mindestens eine Aluminiumschicht umfasst.

Die Abschirmung von elektromagnetischen Wellen wird immer wichtiger, da diese zunehmend Verbreitung finden. Hierbei ist zu berücksichtigen, dass die Verwendung von mobilen Telefonen, insbesondere Handys, weit verbreitet ist. Andererseits finden die hierfür notwendigen Basisstationen aufgrund der Abstrahlung von elektromagnetischen Wellen zunehmend geringere Akzeptanz. In diesem Zusammenhang ist festzuhalten, dass elektromagnetische Wellen insbesondere im Bereich von mehreren Megahertz bis Gigahertz, je nach Intensität, gesundheitsschädliche Wirkungen haben kann. Diese Problematik wird insbesondere unter dem Stichwort "Elektrosmog" diskutiert.

Aus diesen Gründen ist es notwendig, insbesondere die Gebäude, auf denen die Sendemasten dieser Basisstationen angebracht werden, sowie die Gebäude im Umfeld gegen die Wirkung von elektromagnetischen Wellen abzuschirmen.

Materialien zur Abschirmung von elektromagnetischen Wellen sind an sich bekannt. So beschreibt beispielsweise das Gebrauchsmuster DE20215027 ein textiles Flächengebilde zur Abschirmung von elektromagnetischen Wellen. Allerdings wird die darin dargelegte Lehre nur ungenügend beschrieben. So fehlen jegliche Darlegungen der exakten Materialien sowie die Zusammensetzung der darin beschriebenen Schichtmaterialien. So fehlt insbesondere die Beschreibung, welches der Bestandteile metallischer Art sein sollte, sowie die Darlegung der zu verwendenden Metalle. So fehlt insbesondere auch die Schichtdicke der möglicherweise einzusetzenden weiteren Lage.

Darüber hinaus beschreibt die Schrift US-A-2002/0148626 die Verwendung von Schichtmaterialien zur Absorption von elektromagnetischen Wellen oberhalb einer Wellenlänge von 1 GHz. Die in US 2002/0148626 beschriebenen Materialien umfassen zwei Schichten, wobei eine Schicht ein Faservlies darstellt, welches sowohl nichtmetallische als auch metallische Fasern umfasst. Die zweite Lage stellt eine Metallschicht dar, die elektromagnetische Wellen reflektieren kann. Die Dicke der jeweiligen Schichten wird in US 2002/0148626 nicht offenbart. Andererseits ergibt sich aus den Beispielen die Notwendigkeit, dass die Faservliesschicht einen bestimmten Anteil an Metallfasern umfasst. Nimmt der Anteil an Metallfasern ab, so sinkt die Absorption der elektromagnetischen Wellen signifikant. Gleiches gilt, falls der Anteil an Metallfasern zu hoch ist.

Nachteilig an den in US 2002/0148626 dargelegten Schichtmaterialien ist insbesondere deren aufwändige Herstellmethode. So wird insbesondere ein hoher Anteil an Metallfasern benötigt, der einerseits die Schichtmaterialien recht teuer macht, andererseits die Verarbeitbarkeit sowie die mechanischen Eigenschaften nachteilig beeinflusst. Des Weiteren können die Metallfasern oxidieren, wodurch die Haltbarkeit der Materialien beeinträchtigt wird.

Aufgabe der vorliegenden Erfindung ist es somit, elektromagnetische Wellen absorbierende Materialien zur Verfügung zu stellen, die besonders einfach hergestellt werden können. So sollten die zu verwendenden Materialien in großem Umfang und kostengünstig erhältlich sein. Darüber hinaus sollten die Materialien, die die elektromagnetischen Wellen absorbieren, in großem Maßstab herstellbar sein.

Weiterhin war es eine Aufgabe der vorliegenden Erfindung Schichtmaterialien anzugeben, die eine besonders hohe mechanische Stabilität aufweisen. Des Weiteren sollten die Schichtmaterialien eine hohe Lebensdauer aufweisen.

Gelöst werden die zuvor dargelegten Aufgaben durch die Verwendung mit allen Merkmalen des Patentanspruchs 1. Bevorzugte Ausführungsformen der erfindungsgemäßen Verwendung werden in den Ansprüchen 2 bis 16 unter Schutz gestellt.

Dadurch, dass die Aluminiumschicht eines Schichtmaterials, umfassend mindestens eine faserumfassende Schicht sowie mindestens eine Aluminiumschicht, eine Dicke von mindestens 10 µm aufweist, gelingt es, ein Schichtmaterial zur Abschirmung von elektromagnetischen Wellen zur Verfügung zu stellen, das preisgünstig in großem Maßstab hergestellt werden kann.

Des Weiteren werden durch die vorliegende Erfindung folgende Vorteile erzielt:

Die zu verwendenden Schichtmaterialien können zur Abdichtung von Dächern eingesetzt werden.

Die zu verwendenden Schichtmaterialien weisen hervorragende mechanische Eigenschaften auf. Des Weiteren zeigen diese Materialien eine lange Lebensdauer.

Die Herstellung der zu verwendenden Schichtmaterialien kann auf konventionellen Anlagen durchgeführt werden.

Die zu verwendenden Schichtmaterialien können einfach in großem Maßstab bearbeitet werden.

Die zu verwendenden Schichtmaterialien zeigen über einen großen Frequenzbereich eine hervorragende Abschirmung von elektromagnetischen Wellen.

Die zu verwendenden Schichtmaterialien umfassen mindestens eine faserumfassende Schicht. Derartige faserumfassende Schichten sind an sich bekannt. Hierzu gehören unter anderem Gewebe, Gestricke, Gewirke, Gelege, Faserbündel sowie Faservliese.

Besonders bevorzugt stellt die faserumfassende Schicht ein Vliesstoff dar.

Besonders bevorzugt umfasst die faserumfassende Schicht Kunststofffasern. Zu den hierfür geeigneten Kunststoffen zählen insbesondere Polyamide, Polyvinylalkohol oder Polyester. Besonders bevorzugt umfasst die faserumfassende Schicht Polyesterfasern, insbesondere Polyethylenterephthalat, Polybutylenterephthalat und Polytrimethylterephthalat.

Die Verwendung von Metallfasern in der faserumfassenden Schicht ist zur Erzielung der Abschirmung von elektromagnetischen Wellen nicht notwendig. Da die Verwendung derartiger Fasern mit vielerlei Nachteilen verbunden ist, umfasst die faserumfassende Schicht bevorzugt höchstens 5 Gewichtsprozent, besonders bevorzugt höchstens 1 Gewichtsprozent Metallfasern. Gemäß einem ganz besonders bevorzugten Aspekt der vorliegenden Erfindung umfasst die faserumfassende Schicht keinen messbaren Anteil an Metallfasern.

Die faserumfassende Schicht, insbesondere die Vliesstoffe, können verfestigt werden. Diese Verfestigung kann mechanisch, thermisch oder durch die Verwendung von Bindemittel erfolgen. Die hierzu notwendigen Schritte sind dem Fachmann bekannt. So kann die Verfestigung mechanisch durch einen Nadelstuhl, thermisch durch das Verkleben der in der Hitze an der Oberfläche weich gewordenen Fasern erfolgen. Sämtliche Verfestigungsmethoden können jeweils für sich allein oder in Kombination mit einer oder mehreren der anderen Verfestigungsmethoden angewandt werden, wie es im Stand der Technik bekannt ist.

Die faserumfassende Schicht weist bevorzugt eine Dicke im Bereich von 0,4 bis 2 mm auf.

Die faserumfassende Schicht kann ein Flächengewicht im Bereich von 100 - 400 g/m², besonders bevorzugt von 150 - 300 g/m² aufweisen.

Auf mindestens einer Seite der faserumfassenden Schicht wird eine Aluminiumschicht, beispielsweise eine Aluminiumfolie, aufgebracht. Die Aluminiumschicht weist eine Dicke von mindestens 10 µm, bevorzugt mindestens 13 µm und ganz besonders bevorzugt mindestens 14 µm auf.

Vorzugsweise weist die Aluminiumschicht eine Dicke von höchstens 150µm, besonders bevorzugt höchstens 100 µm und ganz besonders bevorzugt höchstens 50 µm auf.

Erfindungsgemäß verwendbare Aluminiumschichten sind an sich bekannt, wobei diese Schicht neben Aluminium weitere Bestandteile umfassen kann. Bevorzugt beträgt der Anteil an Aluminium mindestens 50 Gew.-%, besonders bevorzugt mindestens 80 Gew.-% und ganz besonders bevorzugt mindestens 98 Gew.-%, bezogen auf das Gewicht der Aluminiumschicht.

Vorzugsweise weist die Aluminiumschicht eine Leitfähigkeit im Bereich von 0,34*10⁸ bis 0,38*10⁸ S/m , besonders bevorzugt etwa 0,37*10⁸ S/m auf.

Die Aluminiumschicht kann bevorzugt als Folie ausgebildet sein, wobei andere Ausgestaltungen, beispielsweise als Gewebe oder als Vlies ebenfalls möglich sind.

Vorzugsweise kann die Aluminiumschicht mit der faserumfassenden Schicht in Kontakt stehen, wobei die Verbindung von Aluminiumschicht und der faserumfassenden Schicht in der Fachwelt bekannt ist. Diese kann beispielsweise mechanisch sowie durch Bindemittel erfolgen.

Die Aluminiumschicht kann eine Dehnungsreserve in mindestens einer Richtung im Bereich von 2- 35 %, bevorzugt 3- 30 % und besonders bevorzugt 10 - 20 %, bezogen auf die Länge der faserumfassenden Schicht in dieser Richtung, aufweisen. Durch diese vorteilhafte Ausgestaltung kann das erfindungsgemäß zu verwendende Schichtmaterial mit einer Bitumenschicht versehen werden, wodurch diese als Dachbahn eingesetzt werden kann. Derartige besonders bevorzugte Schichtmaterialien sind insbesondere in DE-A-2827136 beschrieben.

Sowohl die Aluminiumschicht als auch die faserumfassende Schicht, insbesondere ein Vliesstoff, können bevorzugt mit einer Perforation versehen werden, die von einer Nadelung mit einem Nadelstuhl oder mit einer Nadelperforationsmaschine stammen kann. Diese Perforation kann dem besseren Eindringen von Kleber und Bitumen in den Vliesstoff sowie in einer Gasdurchlässigkeit des Vliesstoffes und der Metallfolie dienen.

Vorzugsweise umfasst zumindest die Aluminiumschicht eine Perforation, wobei die perforierte Fläche zwischen 8 und 15 %, insbesondere zwischen 10 und 15 % der Grundfläche der faserumfassenden Schicht betragen kann.

Gemäß einem besonderen Aspekt der vorliegenden Erfindung kann das Schichtmaterial ein Flächengewicht im Bereich von 220 bis 250 g/m² aufweisen.

Gemäß einem besonderen Aspekt der vorliegenden Erfindung kann das zu verwendende Schichtmaterial mit einer Bitumenschicht versehen werden, um als Dachbahn zu dienen. Bitumierte Dachbahnen sowie die hierzu notwendigen Verfahrensschritte sind in der Fachwelt weithin bekannt, wobei dies beispielsweise in der Offenlegungsschrift DE-A-2827136 sowie dem Gebrauchsmuster G 9101083.7 mit dem Anmeldetag 31.01.1991 beschrieben ist.

Das verwendete Bitumen ist bekannt, wobei geblasenes sowie modifiziertes Bitumen eingesetzt werden kann. Hierbei kann das Bitumen mit Kautschuk, insbesondere mit ataktischem Polypropylen modifiziert werden. Des Weiteren kann das Bitumen flammhemmende Substanzen enthalten. Der Auftrag an Bitumen kann auf beiden Seiten des Schichtmaterials eine gleiche oder eine unterschiedliche Dicke aufweisen.

Gemäß einem besonderen Aspekt kann die Aluminiumschicht geerdet werden.

Nachfolgend wird vorliegende Erfindung durch ein Beispiel beschrieben, ohne dass hierdurch eine Begrenzung erfolgen soll.

### Beispiel 1

Ein mit einer Aluminiumschicht versehenes Polyestervlies (Vliestyp 053/250. g/m², kommerziell erhältlich von Johns Manville unter der Handelsbezeichnung (Dura Spun) wurde in Anlehnung an das Verfahren gemäß IEEE STD 299-1997 im Frequenzbereich von 220 MHz bis 10 GHz mit linear polarisierten Wellen vermessen. Zu diesem Zweck wurde das zu prüfende Textilmuster vor einer 80 cm x 60 cm großen Öffnung einer Metallwand (Fläche 210 cm x 200 cm) platziert. Dabei wurde sichergestellt, dass die Materialprobe ganzflächig zu der Metallplatte des Messaufbaus Kontakt hatte. Zur Messung der unterschiedlichen Polarisationen wurde das Muster um 90° Grad gedreht.

Nach der Kalibrierung der Messstrecke wurde die Schirmdämpfung des Messobjekts - bedingt durch die Frequenzbänder der Mesantennen in zwei Frequeriz-Bereichen durchgeführt:
Bereich 1: 220 MHz bis 2.200 MHz
Bereich 2: 1 GHz bis 10 GHz

Die Spitzen der logarithmisch-periodischen Messantennen wurde gemäß IEE STD 299-1997 jeweils 30 cm vor bzw. hinter dem Prüfling positioniert. Es wurden folgende Messgeräte verwendet:
Vektorieller Netzwerkanalysator Typ 360 (40 MHz bis 18,6 GHz), Firma Wiltron
Messantennen: Bilog-Antenna, Typ CBL 6112A (30 MHz bis 2.000 MHz), Firma Case
Messantennen: Logper-Antennen Typ HL025 (1 GHz bis 18 GHz); Firma Rohde und Schwarz

Oberhalb von 500 MHz lag die Schirmdämpfung bei fast 50 dB, das bedeutet dass 99,999 % der auftretenden Leistung abgeschirmt werden, nur 0,001 % dringen hindurch.

Diese herausragenden Werte gelten sowohl für Signale des Mobilfunknetzes im D-Netz (900 MHz) und im E-Netz (1800 MHz). Am oberen gemessenen Frequenzrand liegt die Dämpfung immer noch bei ausgezeichneten ca. 47 dB.

## Patentansprüche

1. Verwendung von einem Schichtmaterial zur Abschirmung von elektromagnetischen Wellen, wobei das Schichtmaterial mindestens eine Faser umfassende Schicht sowie mindestens eine Aluminiumschicht umfasst, **dadurch gekennzeichnet, dass** die Aluminiumschicht eine Dicke von mindestens 10 µm aufweist.

2. Verwendung gemäß Anspruch 1, **dadurch gekennzeichnet, dass** die Faser umfassende Schicht ein Vliesstoff ist.

3. Verwendung gemäß Anspruch 1 oder 2, **dadurch gekennzeichnet, dass** die Faser umfassende Schicht mindestens ein Bindemittel umfasst.

4. Verwendung gemäß einem der vorhergehenden Ansprüche, **dadurch gekennzeichnet, dass** die Faser umfassende Schicht Polyesterfasern umfasst.

5. Verwendung gemäß einem der vorhergehenden Ansprüche, **dadurch gekennzeichnet, dass** die Faser umfassende Schicht höchstens 1 Gew.-% Metallfasern umfasst.

6. Verwendung gemäß einem der vorhergehenden Ansprüche, **dadurch gekennzeichnet, dass** die Faser umfassende Schicht ein Flächengewicht im Bereich von 100 bis 400 g/m² aufweist.

7. Verwendung gemäß einem der vorhergehenden Ansprüche, **dadurch gekennzeichnet, dass** die Aluminiumschicht eine Dicke von mindestens 13 µm aufweist.

8. Verwendung gemäß einem der vorhergehenden Ansprüche, **dadurch gekennzeichnet, dass** die Aluminiumschicht mit der Faser umfassenden Schicht in Kontakt steht.

9. Verwendung gemäß einem der vorhergehenden Ansprüche, **dadurch gekennzeichnet, dass** die Aluminiumschicht geerdet ist.

10. Verwendung gemäß einem der vorhergehenden Ansprüche, **dadurch gekennzeichnet**, **dadurch gekennzeichnet, dass** die Aluminiumschicht eine Leitfähigkeit von 0,37*10⁸ S/m aufweist.

11. Verwendung gemäß einem der vorhergehenden Ansprüche, **dadurch gekennzeichnet, dass** die elektromagnetischen Wellen eine Frequenz im Bereich von 500 MHz bis 18 GHz aufweist.

12. Verwendung gemäß einem der vorhergehenden Ansprüche, **dadurch gekennzeichnet, dass** die Faser umfassende Schicht eine Dicke im Bereich von 0,4 bis 2 mm aufweist.

13. Verwendung gemäß einem der vorhergehenden Ansprüche, **dadurch gekennzeichnet, dass** das Schichtmaterial ein Flächengewicht im Bereich von 220 bis 250 g/m² aufweist.

14. Verwendung gemäß einem der vorhergehenden Ansprüche, **dadurch gekennzeichnet, dass** die Aluminiumschicht eine Dehnungsreserve in mindestens einer Richtung im Bereich von 2 bis 35%, bezogen auf die Länge der Faser umfassende Schicht in dieser Richtung aufweist.

15. Verwendung gemäß einem der vorhergehenden Ansprüche, **dadurch gekennzeichnet, dass** die Aluminiumschicht eine Perforation aufweist.

16. Verwendung gemäß Anspruch 15, **dadurch gekennzeichnet, dass** die perforierte Fläche zwischen 8 und 15%, insbesondere zwischen 10 und 15%, der Grundfläche der Faser umfassenden Schicht beträgt.
